# EUROPÄISCHE PATENTANMELDUNG

(11) **EP 0 943 704 A2**
(43) Veröffentlichungstag der Anmeldung: **22.09.1999**
(21) Anmeldenummer: 99100622.2
(22) Anmeldetag: 14.01.1999
(51) Int. Cl.: C30B 15/20

(54) **Einrichtung zum Steuern von Kristallzüchtungsprozessen**

(30) Priorität: 19.02.1998 DE 19806949
(71) Anmelder: Leybold Systems GmbH, 63450 Hanau (DE)
(72) Erfinder: Altekrüger, Burkhard, Dr., 63755 Alzenau (DE); Aufreiter, Joachim, Ing., 63755 Alzenau (DE); Brüss, Dieter, Dipl.-Ing., 63486 Bruchköbel (DE); Kalkowski, Klaus, Dipl.-Ing., 63584 Gründau-Rothenbergen (DE)
(74) Vertreter: Schickedanz, Willi, Dipl.-Ing.

(57) **Zusammenfassung**

Die Erfindung betrifft eine Einrichtung zum Steuern von Kristallzüchtungsprozessen, welche verschiedenartige Prozeß-Phasen - z. B. Einschmelzen oder Abkühlen - durchlaufen und bei denen die Form des Kristalls während der Züchtung verschiedene Bereiche aufweist, beispielsweise einen Hals und/oder eine Schulter. Jedem einzelnen dieser Bereiche und Phasen sind dabei bestimmte Prozeßparameter und Zielgrößen sowie Eingangswerte und Ausgangswerte zugeordnet, beispielsweise ein bestimmter Gasdruck oder eine bestimmte Kristall-Drehgeschwindigkeit. Die Verknüpfung dieser Größen erfolgt durch Funktionsgeneratoren oder Tabellen. Mit Hilfe einer erfindungsgemäßen Regelvorrichtung wird es ermöglicht, bei grundsätzlich gleichartigem Aufbau und übersichtlicher Struktur für jede der speziellen Prozeßphasen und Kristallabschnitte eine speziell angepaßte Verknüpfung der jeweils erforderlichen Ein- und Ausgangsgrößen zu erzeugen. Das ermöglicht eine optimierte Prozeßführung mit hoher Reproduzierbarkeit, bei der manuelle Eingriffe des Bedienpersonals während des gesamten Prozesses und auch während der Übergangsphasen zwischen verschiedenen Prozeßabschnitten nicht mehr erforderlich sind.

## Beschreibung

Die Erfindung betrifft eine Einrichtung nach dem Oberbegriff des Patentanspruchs 1.

Unter einem Einkristall versteht man einen einzigen homogenen Kristall, dessen Atome äquidistant in einem dreidimensionalen Gitter angeordnet sind. Einkristalle unterscheiden sich somit von anderen Festkörpern, z. B. den polykristallinen oder amorphen Körpern, durch ihre reguläre Struktur, die auch in ihrem Äußeren zum Ausdruck kommt.

Um solche Einkristalle zu züchten, werden entsprechende Materialien, z. B. Germanium oder Silizium, zunächst geschmolzen und dann aus dieser Schmelze Kristalle durch bestimmte Prozesse gewonnen.

Bei den meisten dieser Prozesse ist Voraussetzung, daß sich entweder nur ein Keim bildet oder ein Keim bevorzugt schnell wächst. Stabförmige Einkristalle mit rundem Querschnitt werden in der Regel durch Erstarren aus der Schmelze im Temperaturgefälle hergestellt. Bei diesen Prozessen, zu denen das sogenannte Bridgman-Verfahren gehört, befindet sich die Schmelze in einem Tiegel, der mit einer konstanten, der Kristallisationsgeschwindigkeit des jeweiligen Materials angepaßten Geschwindigkeit durch ein 10 - 100 Grad/cm betragendes, den Schmelzpunkt einschließendes Temperaturgefälle bewegt wird.

In Abwandlung dieses Prinzips wird auch das sogenannte Zonenschmelzen angewendet.

Beim Ziehen aus der Schmelze, dem sogenannten "Czochralski-Verfahren", wird ein kleines einkristallines Stück des Materials, der Impfkristall, in die Schmelze getaucht und nach Einstellung des Temperaturgleichgewichts an der Grenzfläche zwischen flüssig und fest mit gleichmäßiger Geschwindigkeit herausgezogen. Diese Geschwindigkeit wird geregelt. Dabei kristallisiert ständig weiteres Material am unteren Ende des entstehenden Einkristalls an.

Die physikalischen Größen, mit denen das Wachstum eines solchen Einkristalls beeinflußt werden kann, sind beispielsweise die Temperatur der Schmelze oder die Ziehgeschwindigkeit.

Damit die vorstehend erwähnten oder anderen Einkristall-Herstellungs-Prozesse ordnungsgemäß ablaufen, sind besondere Regelverfahren bzw. -einrichtungen erforderlich.

Um bei einem Czochralski-Prozeß den Querschnitt des gezogenen Kristalls zu regeln, ist bereits eine Einrichtung bekannt, mit der ein erstes Signal, das der Trägheitsmasse des Kristalls entspricht, mit einem zweiten Signal verglichen wird, das einem Referenzsignal entspricht (Britische Patentschrift 1 457 275). Dieses Referenzsignal entspricht zu jeder Zeit einem Erwartungswert für das erste Signal. Die Abweichung zwischen den beiden Signalen wird für die Regelung des Querschnitts herangezogen. Dabei werden die Heizung für die Schmelze und ein Elektromotor für den Antrieb einer Kristall-Hebestange geregelt.

Nachteilig ist bei diesem Regelungsverfahren, daß mit ihm nur eine Größe geregelt werden kann, nämlich der Querschnitt des gezogenen Kristalls. Eine Regelung der verschiedenen Bereiche eines Kristalls, z. B. dem Hals oder der Schulter, ist mit dem bekannten Verfahren nicht möglich.

Es ist weiterhin ein Verfahren zur Steuerung des Wachstums eines Kristalls bekannt, bei welchem das Wachstum durch einen Satz von meßbaren und nicht meßbaren Variablen bestimmt wird (Europäische veröffentlichte Patentanmeldung 0 821 082). Dieses Verfahren besteht darin, daß eine On-line-Simulations-Software mit einer reduzierten Anzahl von Variablen hergestellt wird, wobei die Reduktion der Variablen durch die Verwendung eines Projektions-Algorithmus erzielt wird. Sodann wird diese Software beschleunigt, indem eine Datenbank erzeugt wird, in welcher Werte von off-line vorberechneten Variablen gespeichert werden. Hierauf wird die On-line-Simulations-Software mit den Ergebnissen abgestimmt, welche durch die Off-line-Simulation und durch Messungen erhalten werden, indem die Ergebnisse eingestellt werden, welche durch die On-line-Simulationen vorhergesagt wurden. Nun wird eine Regelschleife gebildet, und es wird wenigstens eine der Variablen in Realzeit geregelt, wobei die Regelschleife die beschleunigte und abgestimmte On-line-Simulation als einen On-line-Beobachter verwendet. Zu den meßbaren und nicht meßbaren Variablen gehören hierbei Ziehgeschwindigkeit, Heizleistung, Temperaturverteilung im Kristall, Schmelzflußeigenschaften, Temperaturverteilung auf der inneren Oberfläche des Quarz-Tiegels, Temperaturverteilung auf der Oberfläche der Schmelze, die Form der Fest-Flüssig-Grenze und die Verdampfung von SiO. Nachteilig ist bei diesem Verfahren, daß bei der Regelung unterschiedlicher Abschnitte eines Kristalls, z. B. des Halses oder des Körpers, auch unterschiedliche Strategien angewendet werden.

Der Erfindung liegt die Aufgabe zugrunde, bei allen verschiedenen Bereichen eines Kristalls die gleichen Regelstrategien zugrundezulegen.

Diese Aufgabe wird gemäß den Merkmalen des Patentanspruchs 1 gelöst.

Der mit der Erfindung erzielte Vorteil besteht insbesondere darin, daß z. B. der prozentuale Anteil eines Kristall-Halses am Gesamtkristall festgelegt und automatisch geregelt werden kann. Außerdem können auch weitere Phasen des Züchtungsprozesses, z. B. der Einschmelzvorgang des Ausgangsmaterials oder der Abkühl-Vorgang von Kristall und Restschmelze, geregelt werden.

Weiterhin ist es möglich, daß mit der erfindungsgemäßen Regelungseinrichtung der gesamte Züchtungsprozeß, beginnend mit dem Evakuieren der Anlage - Pump down - bis zur Züchtung des letzten Kristallabschnitts - end cone - sowie der Abkühlphase, völlig selbsttätig durchgeführt werden kann. Die Erfindung betrifft somit ein Verfahren zum Steuern von Kristallzüchtungsprozessen, welche verschiedenartige Prozeß-Phasen - z. B. Einschmelzen oder Abkühlen - durchlaufen und bei denen die Form des Kristalls während der Züchtung verschiedene Bereiche aufweist, beispielsweise einen Hals und/oder eine Schulter. Jedem einzelnen dieser Bereiche und Phasen sind dabei bestimmte Prozeßparameter und Zielgrößen sowie Eingangswerte und Ausgangswerte zugeordnet, beispielsweise ein bestimmter Gasdruck oder eine bestimmte Kristall-Drehgeschwindigkeit. Die Verknüpfung dieser Größen erfolgt durch Funktionsgeneratoren oder Tabellen. Mit Hilfe einer erfindungsgemäßen Regelvorrichtung wird es ermöglicht, bei grundsätzlich gleichartigem Aufbau und übersichtlicher Struktur für jede der speziellen Prozeßphasen und Kristallabschnitte eine speziell angepaßte Verknüpfung der jeweils erforderlichen Ein- und Ausgangsgrößen zu erzeugen. Das ermöglicht eine optimierte Prozeßführung mit hoher Reproduzierbarkeit, bei der manuelle Eingriffe des Bedienpersonals während des gesamten Prozesses und auch während der Übergangsphasen zwischen verschiedenen Prozeßabschnitten nicht mehr erforderlich sind.

Ein Ausführungsbeispiel der Erfindung ist in den Zeichnungen dargestellt und wird im folgenden näher beschrieben. Es zeigen:
- Fig. 1: die Prinzipdarstellung eines Kristall-Ziehprozesses, bei dem mehrere Sensoren zum Einsatz kommen;
- Fig. 2: verschiedene Bereiche eines Kristalls, die bei einem Kristall-Ziehprozeß auftreten;
- Fig. 3: ein Grundschema für die Realisierung der Erfindung;
- Fig.: 4 ein Schema, das beim Aktivieren der Position 137 in Fig. 3 erscheint;
- Fig. 5: den zeitlichen Ablauf der in Fig. 4 gezeigten Aktivitäten;
- Fig.: 6 Monitor-Darstellungen für einen Kristallzüchtungsprozeß im Halsbereich des Kristalls;
- Fig. 7: eine aus einer Zahlentabelle ähnlich Fig. 6 abgeleitete geometrische Funktion;
- Fig. 8: eine Anordnung für die Realisierung von Prozeßgrößen mittels Funktionsgeneratoren;
- Fig. 9: eine Prinzip-Gesamtansicht der erfindungsgemäßen Anordnung.

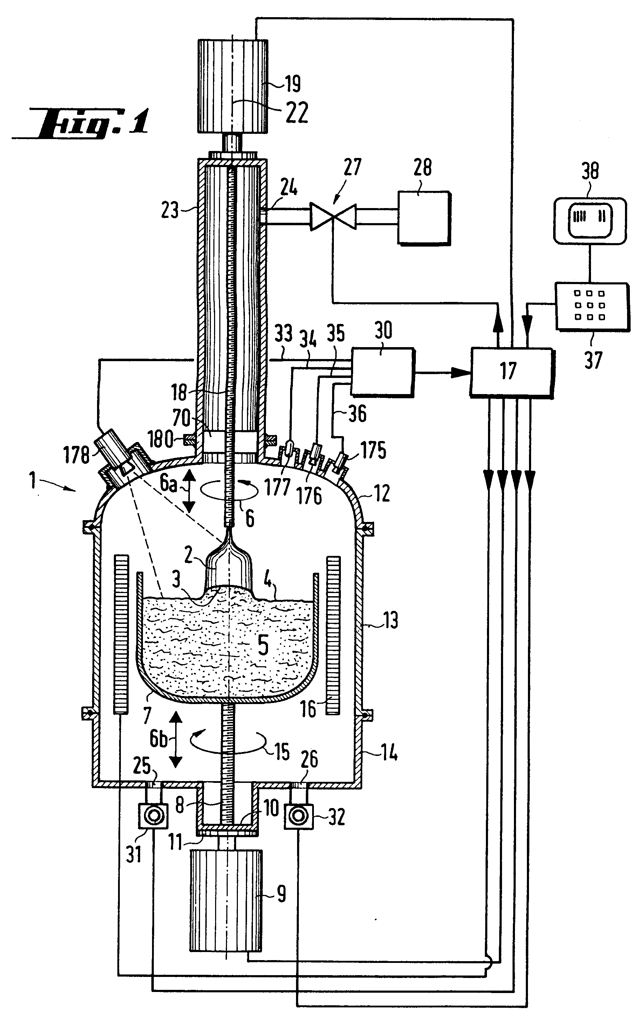

In der Fig. 1 ist eine Vorrichtung 1 dargestellt, mit der es möglich ist, einen Kristall 2, dessen Unterseite 3 mit der Oberfläche 4 einer Schmelze 5 in Verbindung steht, aus dieser Schmelze 5 zu ziehen. Der Kristall wird hierbei im Sinne eines Pfeils 6 gedreht und im Sinne des Pfeils 6a vertikal verfahren. Die Schmelze 5 befindet sich in einem Tiegel 7, der mittels einer Welle 8 von einem Dreh- und Hubantrieb 9 angetrieben wird. Welle 8 und Motor 9 sind miteinander verbunden. Der Tiegel 7 befindet sich in einem Gehäuse (Prozeßkammer), das aus einem oberen Teil 12, einem mittleren Teil 13 und einem unteren Teil 14 besteht und ist im Sinn der Pfeile 15, 6b drehbar und vertikal verfahrbar. Um den Tiegel 7 herum ist eine elektrische Heizeinrichtung 16 angeordnet, die mit elektrischer Energie versorgt wird.

Die Drehung des Kristalls 2 erfolgt mittels einer Stange 18 die von einem Dreh- und Hubantrieb 19 angetrieben wird. Dieser Dreh- und Hubantrieb 19 wird ebenfalls aus der Einrichtung 17 mit elektrischer Energie versorgt.

Die Stange 18, deren vertikale Achse mit 22 bezeichnet ist, ist von einer rohrförmigen Schleusenkammer 23 umgeben, welche mit dem oberen Teil 12 des Gehäuses in Verbindung steht. Diese Schleusenkammer 23 weist eine Gaseinlaßöffnung 24 auf, während im Bodenteil 14 des Gehäuses Gasauslaßöffnungen 25, 26 vorgesehen sind. Die Stange 18 kann mittels des Dreh- und Hubantriebs 19 nicht nur gedreht, sondern auch angehoben werden. Die Steuerung der Antriebe 9, 19 erfolgt über die Einheit 17, die mit verschiedenen Betriebszustands-Informationen aus einer Einrichtung 30 versorgt wird. Die Einheit 17 steuert auch ein Ventil 27, welches zwischen einem Gas-Reservoir 28 und der Gaseinlaßöffnung 24 angeordnet ist. Mit diesem Ventil 27 kann der Zustrom eines Gases in das Rohr 23 und damit in den Behälter 12, 13, 14 gesteuert werden.

An den Gasauslaßöffnungen 25, 26 sind Pumpen 31, 32 vorgesehen, mit denen Gas im Behälter 12, 13, 14 abgesaugt werden kann. Die Steuerung dieser Pumpen 31, 32 erfolgt hierbei über die Einheit 17. Mit 33 bis 36 sind verschiedene Eingänge der Einrichtung 30 bezeichnet. Diese Eingänge 33 bis 36 symbolisieren verschiedene Parameter der Vorrichtung 1, die beispielsweise durch Sensoren erfaßt werden. So kann am Eingang 33 ein Meßwert anstehen, der sich auf die mittels einer Kamera 178 erfaßte Kontur des Kristalls bezieht. Am Eingang 34 kann ein Meßwert anstehen, der von einem Gasdruck-Meßgerät 177 geliefert wird, während an den Eingängen 35, 36 Daten über die von Pyrometern 175, 176 gelieferten Temperaturen der Schmelze 5 bzw. der Heizeinrichtung 16 anstehen können. Es versteht sich, daß die erwähnten Meßgrößen nur beispielhaft genannt sind. Selbstverständlich können mehr als vier und andere Meßgrößen, z. B. gemessene Drehzahlen der Motoren 9, 19, am Eingang der Einrichtung 30 anstehen. Aufgabe der Einrichtung 30 ist es, die Meßdaten in einer für die Einheit 17 geeigneten Form aufzubereiten. Mit 37 ist eine Eingabetastatur bezeichnet, mit welcher bestimmte Vorgaben gemacht werden können. Diese Eingabetastatur 37 kann mit einem Monitor 38 verbunden sein, auf dem die Vorgaben und Daten angezeigt werden.

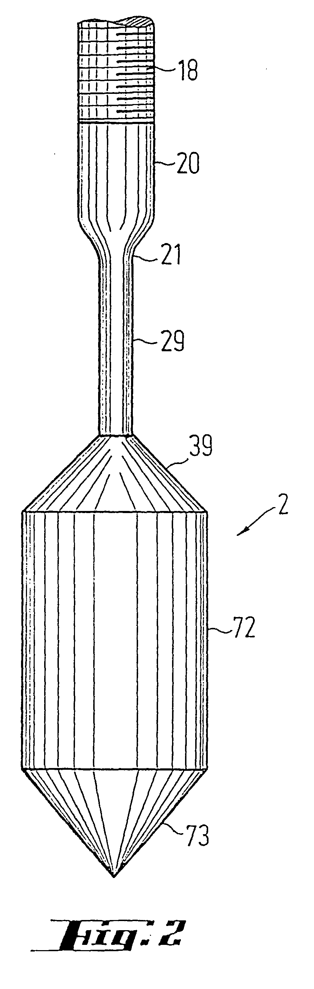

In der Fig. 2 ist ein gezogener Kristall 2 mit seinen verschiedenen Bereichen gezeigt, die sich bei unterschiedlichen Stadien des Kristallziehprozesses ergeben. Die Darstellung des Kristalls 2 erfolgt zu Zwecken der Eindeutigkeit und Klarheit der verwendeten Begriffe. Da diese Begriffe auf internationaler Ebene in englischer Sprache angegeben werden, sind hinter den deutschen Begriffen in Klammern auch noch die englischen Begriffe gesetzt. Es versteht sich, daß sich der in der Fig. 2 dargestellte Kristall zwar auf den Czochralski-Prozeß bezieht, aber die Erfindung nicht auf diesen Prozeß beschränkt ist.

An der Stange 18 ist mittels eines Impflinghalters (engl. seed chuck) ein Impfling 20 (engl. seed) vorgesehen, der dann, wenn er in die Schmelze 5 eingetaucht und wieder hochgezogen wurde, eine Halseinschnürung 21 (engl. taper, neckcone) ausbildet. Im Anschluß an diese Halseinschnürung 21 entsteht beim Herausziehen des Kristalls 2 ein Hals 29 (engl. neck), dem sich eine Schulter 39 (engl. shoulder, crown) anschiießt. Diese Schulter 39 geht in den zylindrischen Körper 72 (engl. body) über, der von einem Endkonus 73 (engl. end cone, taper) abgeschlossen wird.

Bei der Herstellung eines Kristalls 2 entstehen die verschiedenen Bereiche 20, 21, 29, 39, 72, 73 zu verschiedenen Zeiten des Herstellungsprozesses. Damit alle diese Bereiche 20, 21, 29, 39, 72, 73 den vorgeschriebenen bzw. vorgegebenen geometrischen Bedingungen genügen, müssen die Zustandsvariablen des Herstellungsprozesses, z. B. Ziehgeschwindigkeit, Rotation, Gasfluß, Gasdruck, Temperatur und dergleichen, in jedem Bereich exakt aufeinander abgestimmt sein.

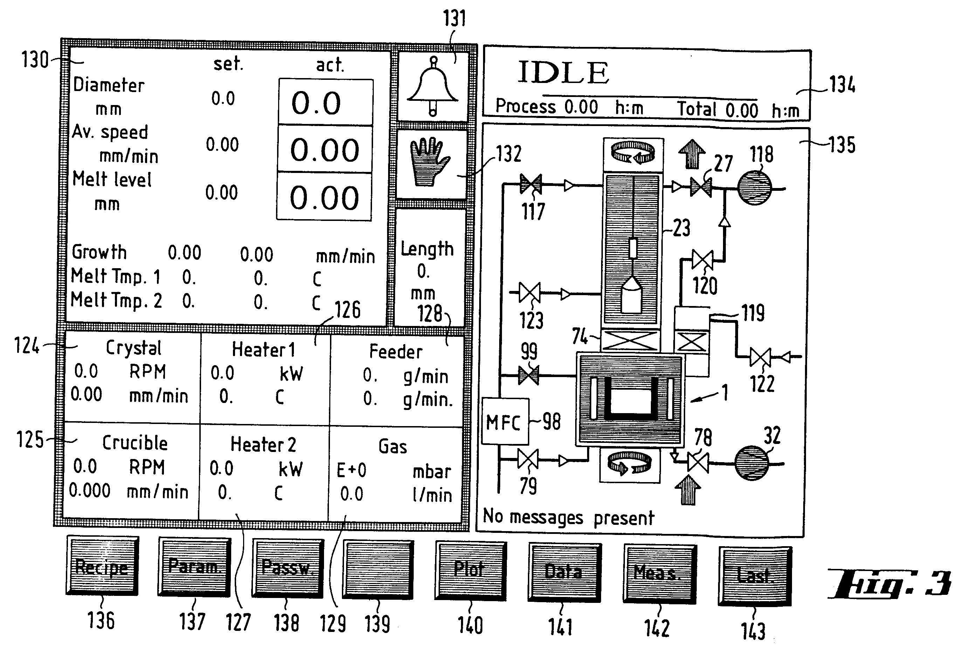

Um diese Abstimmung zu realisieren, wird durch die Bedienung der Tastatur 37 auf dem Bildschirm des Monitors 38 ein Hauptmenü aufgerufen, das in der Fig. 3 dargestellt ist. Dieses Hauptmenü zeigt auf der rechten Seite in symbolisierter Form eine abgeänderte Anordnung der Fig. 1, wobei die unteren Prozeßkammern 14, 13, 12 mittels eines Ventils 74 von der Schleusenkammer 23 getrennt sind. Hierdurch ist es möglich, bei geschlossenem Ventil einen fertigen Kristall 2 aus der Schleusenkammer 23 zu entnehmen und nach der Entnahme mit dem Impfling 20 einen neuen Kristall zu ziehen. Mittels der Pumpe 32 können über ein Ventil 78 Gase abgesaugt und damit der Prozeßdruck geregelt werden. Über ein optional vorgesetztes Ventil 79 kann Gas in den Prozeßraum zur Spülung der Tiegeltragwelle 15 zugeführt werden. Ein Massenflußregler 98 befindet sich vor Ventilen 99 bzw. 117, denen er z. B. Argon-Gas zuführt. Das Ventil 99 hat bei geschlossenem Flutventil 74 die gleiche Funktion wie das Ventil 117. Mit Hilfe des Ventils 27 und einer Pumpe 118 kann die Schleusenkammer separat abgepumpt werden, und zwar bei geschlossenem Flutventil 74. Über die Ventile 122 bzw. 123 kann Argon-Gas aus der Schleusenkammer 23 bzw. einem Nachchargierreservoir 119 zugeführt werden.

In der Fig. 3 sind englische Begriffe beibehalten worden, weil diese englischen Begriffe bei dem realisierten Erfindungsgegenstand ebenfalls verwendet werden. Die deutschen Entsprechungen werden jedoch in der Beschreibung verwendet.

Auf der linken Seite der Hauptmenü-Darstellung ist ein Feld 124 gezeigt, das die Umdrehungszahl der Stange 18 und damit des Kristalls 2 in Umdrehungen pro Minute (RPM) sowie den Hub des Kristalls 2 in mm/min angibt.

In einem weiteren Feld 125 ist die Umdrehungszahl des Tiegels 7 bzw. des Motors 9 in Umdrehungen pro Minute (RPM) bzw. der Hub dieses Tiegels 7 angegeben. Ein weiteres Feld 126 zeigt die elektrische Leistung und die Temperatur einer ersten Heizung 16 an, während ein Feld 127 die elektrische Leistung und Temperatur einer zweiten optionalen und nicht dargestellten Heizung anzeigt.

Im Feld 128 wird die Zuführung von Rohmaterial in den Tiegel 7 durch eine optionale Zuführungsvorrichtung in Gramm pro Minute angezeigt. Die entsprechende Zuführungsvortichtung ist in den Fig. 1 und 3 nicht dargestellt. Der im Behälter 12, 13, 14 herrschende Gasdruck sowie der Gasdurchsatz werden in Feld 129 angezeigt.

Die Felder 124 bis 129 sind ebenfalls "Tasten". So zeigt z. B. die Taste 126 die aktuellen Werte; wird sie gedrückt, erscheint auf der rechten Bildhälfte die Sollwertmaske. Wird die Taste 130 gedrückt, werden die aufgeführten Größen im Bargraph Chart dargestellt. Wird die Taste 131 gedrückt, wird die Alarmliste angezeigt. Wird die Taste 132 gedrückt, erscheint ein Anhang 2. Wird die Taste 134 gedrückt, erscheint ein Anhang 4.

In einem oberen Feld 130 werden Größen wie "Durchmesser", "durchschnittliche Geschwindigkeit", "Schmelzbad-Pegel", "Wachstum" und "Schmelztemperatur 1" bzw. "Schmelztemperatur 2" angezeigt.

Für Störfälle ist in Feld 131 eine Warnglocke dargestellt, während im Feld 132 ein Symbol für den Handbetrieb gezeigt ist. Das Feld 133 zeigt die Gesamtlänge des bereits gezogenen Kristalls an.

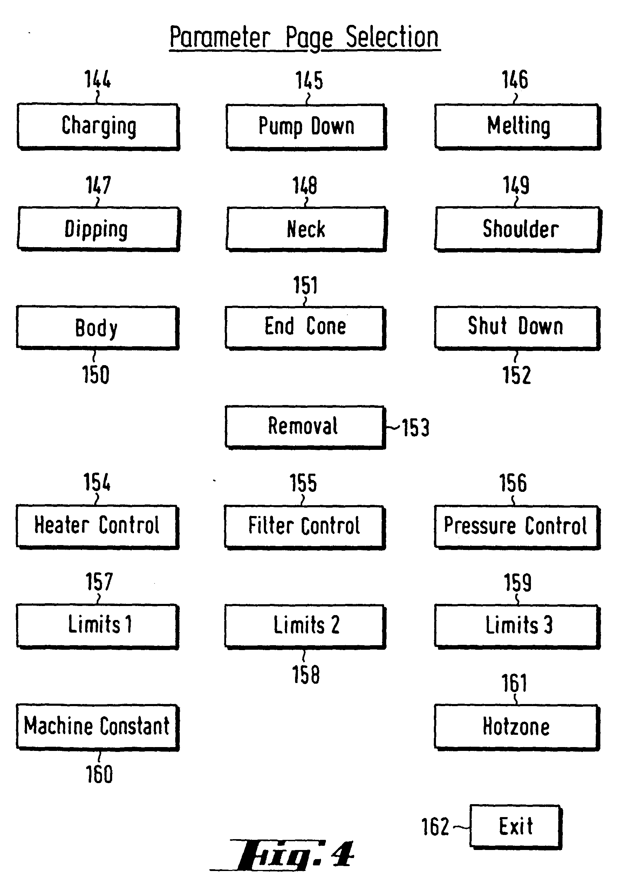

Unterhalb der Felder 124 bis 135 sind mehrere Tasten 136 bis 143 angegeben, in die mit einem Cursor hineingeklickt werden kann. Über die Taste 143 "Last" gelangt man zu der letzten aufgerufenen Parametertafel. Durch Klicken in die Taste 137 "Parameter" wird die in den Fig. 4 gezeigte Anordnung "Parameter Page Selection" aufgerufen.

Diese Anordnung zeigt in drei Spalten und acht Zeilen verschiedene Tasten-Felder 144 bis 162, die per Cursor und Maus angeklickt werden können. Diese Tasten-Felder entsprechen den verschiedenen Phasen des Züchtungsprozesses. Mit den einzelnen Tasten kann folgendes aufgerufen werden: Taste 144: Beschickung; Taste 145: Abpumpen; Taste 146: Schmelzen; Taste 147: Eintauchen; Taste 148: Hals; Taste 149: Schulter; Taste 150: Körper; Taste 151: Endkonus; Taste 152: Abschalten; Taste 153: Entnehmen, Neubeginn; Taste 154: Heizungsregelung; Taste 155: Filter-Regelung; Taste 156: Druckregelung; Taste 157: Begrenzungen 1; Taste 158: Begrenzungen 2; Taste 159: Begrenzungen 3; Taste 160: Maschinenkonstante; Taste 161: Heizeinrichtung; Taste 162: Ausgang. Mit den Tasten 148, 149, 150, 151 werden hierbei diejenigen Bereiche des Kristalls aufgerufen, die in Fig. 2 dargestellt sind.

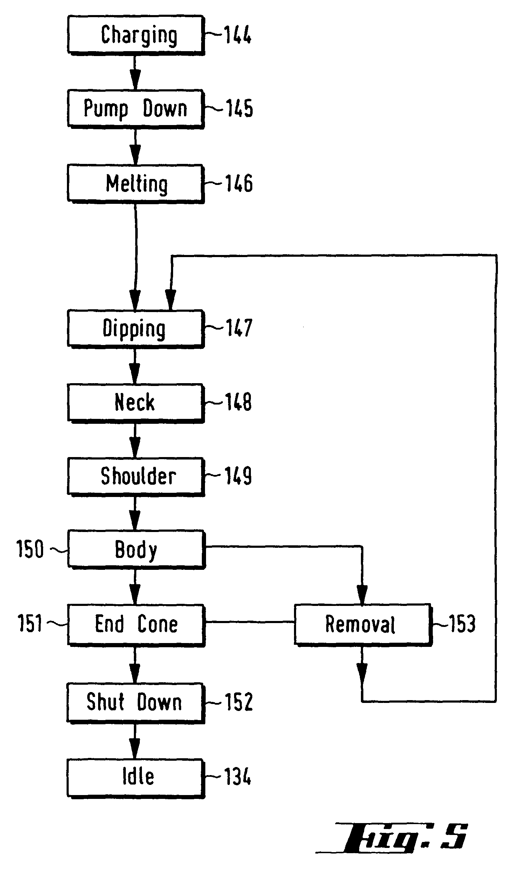

In der Fig. 5 sind noch einmal einige der Tasten der Fig. 4 dargestellt, jedoch in Form eines zeitlichen Ablaufs. Man erkennt aus dem nach Art eines Flußdiagramms dargestellten Prozeß, daß zuerst beschickt wird, dann abgepumpt und geschmolzen. Hierauf wird der Impfling eingetaucht und zuerst der Hals und dann die Schulter bzw. der Körper gezogen. Ist der Endkonus erreicht, wird ein neuer Kristall gezüchtet und wieder mit dem Eintauchen des Impflings begonnen.

Am Ende wird die Anlage abgeschaltet, Shut Down 152, und leergeräumt, Idle 134.

Beim Chargieren oder Beschicken werden zwei Aspekte berücksichtigt: die Geometrie des Tiegels und die Füllstandsberechnung. Der in der Fig. 1 dargestellte Tiegel besteht in der Praxis aus zwei Tiegeln, die ineinandergestellt sind. Der größere Tiegel besteht dabei aus Graphit und dient als Stütztiegel für einen Kleinen Quarztiegel. Der Quarztiegel wird verwendet, damit die Schmelze 5 nicht durch den Graphittiegel verunreinigt wird. Graphit ist als Tiegelmaterial z. B. für Silizium völlig ungeeignet. Die Abmessungen der beiden Tiegel werden entsprechend ihrer tatsächlichen Geometrie eingegeben und sind veränderbar. Abmessungsparameter sind beispielsweise die Wandstärke und die Bodenstärke des Quarztiegels sowie der Innendurchmesser und der Krümmungsradius zwischen dem zylindrischen Teil des Tiegels und seinem Boden.

Bei der automatischen Füllstandsberechnung wird das Gewicht der (z. B. Silizium-) Charge eingegeben und hieraus sowie aus der Tiegelgeometrie der Füllstand berechnet. Der Füllstand kann selbstverständlich auch gemessen werden.

Nach dem Chargieren erfolgt das "Pump down". Hierunter versteht man das Evakuieren des Behälters 12, 13, 14 um den Tiegel 7 herum, wobei festgestellt wird, ob dieser Behälter dicht ist. So kann es z. B. 1000 Sekunden dauern, bis ein Druck von 10.0 mbar erreicht ist. Nach weiteren 1500 Sekunden ist ein Druck von 1.0 mbar erreicht, während nach weiteren 1800 Sekunden ein Druck von 0.1 mbar vorliegt. Bis ein Durck von schließlich 0.05 mbar erreicht ist, sind 2500 Sekunden vergangen. Werden die erwähnten Drücke bei den genannten Zeiten nicht eingehalten, erfolgt eine Alarmmeldung und es kann auf ein Leck im Behälter 12, 13, 14 geschlossen werden.

Nach dem Schmelzvorgang beginnt der eigentliche Kristallziehprozeß, auf den nun näher eingegangen wird.

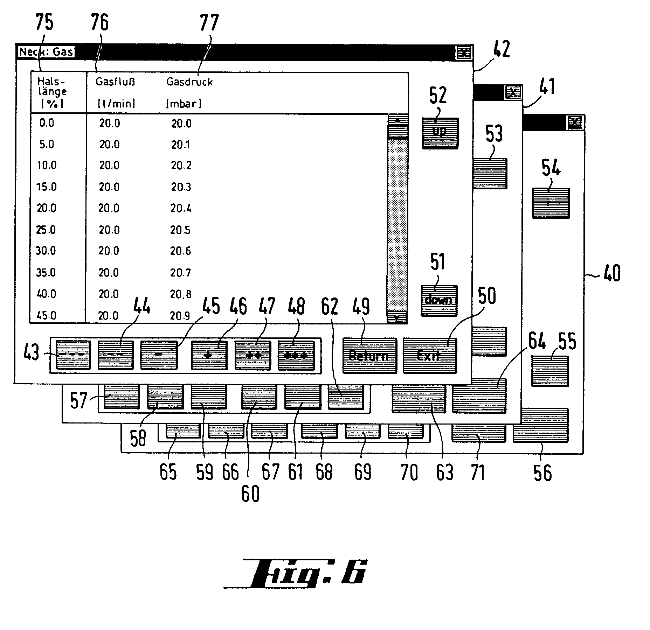

Wird in Fig. 4 beispielsweise die Taste 148 "Neck" angeklickt, so erscheint eine Haupttafel mit Tasten zu verschiedenen Untertafeln wie 40, 41, 42, die in der Fig. 6 dargestellt sind. Alle drei Untertafeln 40, 41, 42 beziehen sich hierbei auf den Hals 29 beim Ziehen des Kristalls 2. Die vordere Untertafel 42 zeigt eine Tabelle, welche die relevanten Daten des Gases bei verschiedenen Längen des Halses 29 beinhaltet.

Auf der linken Seite der Untertafel 42 sind drei Spalten 75, 76, 77 erkennbar, von denen die erste Spalte 75 die Länge des Halses des Kristalls bezeichnet, und zwar in Prozent der Gesamtlänge des Halses. 15 % bedeutet somit, daß der Hals des wachsenden Kristalls 15 % seiner Gesamtlänge erreicht hat. Ab 45 % ist die Tabelle nicht mehr einsehbar, weil dann die Werte verdeckt sind. Die Tabelle kann aber über die Tasten 51, 52 gescrollt werden (down, up).

Die untereinander angeordneten Zeilen stellen somit die Zustände "Halslänge", "Gasfluß" und "Gasdruck" zu bestimmten Zeiten dar. Zum Zeitpunkt t = 0 beträgt beispielsweise die Halslänge 0,0 % der Gesamthalslänge, zum Zeitpunkt t = t₁ beträgt sie 5 % der Gesamthalslänge usw. Der Gasfluß und der Gasdruck, die der jeweiligen Halslänge zugeordnet sind, sind in den Spalten 76 und 77 dargestellt. Man erkennt aus dieser Darstellung, daß zu dem Zeitpunkt` an dem die Halslänge 30 % betragt, ein Gasfluß zu 20.0 l/min bei einem Gasdruck von 20.6 mbar herrscht.

Alle in den Spalten 75, 76, 77 dargestellten Werte, z. B. der Gasdruck, können mit Hilfe eines Cursors geändert werden.

Änderungen können mittels der Tasten 43 bis 48 vorgenommen werden, wobei die Tasten 43 bis 45 für abnehmende Werte und die Tasten 46 bis 48 für aufsteigende Werte stehen. Bei der Taste 49 handelt es sich um eine "Return"-Taste, während die Tasten 50, 51, 52 auf "Exit", "Down" und "Up" hinweisen. Wird die Taste 49 gedrückt, geht es zurück zur Haupttafel. Beim Aktivieren der Taste 50 geht es zum Grundschema zurück. Down 51 bedeutet in der Tabelle eine Zeile tiefer, während Up 52 in der Tabelle eine Zeile höher bedeutet.

Die im Hintergrund gezeigten Untertafeln 41, 40 weisen Tasten 57 bis 62 bzw. 65 bis 70 auf, die den Tasten 43 bis 48 entsprechen. Auch die übrigen Tasten 63, 64 bzw. 71, 56 der Untertafeln 41, 40 korrespondieren zu Tasten 49, 50 der Untertafel 42. Während die Untertafel 42 die Größen "Gasfluß" und "Gasdruck" in bezug auf die Halslänge beschreibt, bezieht sich die Untertafel 41 z. B. auf die Größe "Drehzahl" in bezug auf die Halslänge. Bei der Untertafel 40, die sich gleichfalls auf die Halslänge bezieht, ist die variable Größe z. B. die Temperatur der Schmelze.

Entsprechende Untertafeln, wie sie in Fig. 6 im Zusammenhang mit dem Hals eines Kristalls dargestellt sind, können durch ein entsprechendes Klicken auf die Tasten 149, 150 oder 151 auch für die Schulter, den zylindrischen Körper und den Endkonus des Kristalls dargestellt werden. Man erkennt hieraus, daß jedem Bereich des in der Fig. 2 gezeigten Kristalls sowie jedem Prozeßschritt eigene Parameter zugeordnet sind.

Auch bei den übrigen in der Fig. 4 dargestellten Größen erscheinen, wenn sie angeklickt werden, Untertafeln, die so ausgestaltet sind wie die in der Fig. 6 gezeigten Untertafeln 40, 41, 42. Hierdurch ist es möglich, daß bei den verschiedenen Prozeßschritten, z. B. Herstellung des Halses, Herstellung der Schulter etc., der Verlauf der einzelnen Prozeßgrößen wie Temperatur, Gasfluß, Umdrehungszahl etc., vorgegeben werden kann. Für jeden Prozeßschritt wird eine Reihe von Funktionen generiert, die den Verlauf der verschiedenen Prozeßparameter, z. B. Temperatur, Druck, Durchmesser etc. beim Abarbeiten dieses Schritts definieren.

Diese verfahrenstechnische Lösung erlaubt es, die unterschiedlichsten Philosophien bei der Produktion eines Kristalls mit der gleichen Steuerung zu realisieren.

In der ersten Spalte 75 der Untertafeln 40, 41, 42 steht diejenige Meß- oder Führungsgröße, mit der das Fortschreiten des jeweiligen Prozeßschrittes beschrieben wird, z. B. die Halslänge in % beim Prozeßschritt "Hals" oder die Zeit beim Prozeßschritt "Schmelzen". Im Koordinatensystem können die Werte dieser ersten Spalte 75 beispielsweise auf die x-Achse aufgetragen werden.

In den weiteren Spalten 76, 77 werden andere Prozeßgrößen, z. B. Gasfluß und Gasdruck, dargestellt. Diese Prozeßgrößen können in einem Koordinatensystem auf der y-Achse erscheinen.

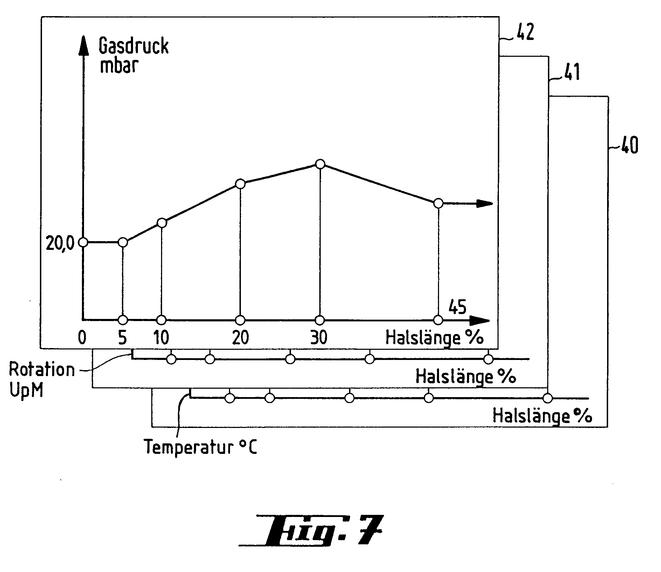

Die Fig. 7 zeigt ein Beispiel einer kurvenmäßigen Darstellung der Abhängigkeit des Gasdrucks von der Halslänge im Koordinatensystem. In der vorderen Untertafel 42 ist die Halslänge in Prozent auf der Abszisse aufgetragen, während der Gasdruck auf der Ordinate aufgetragen ist.

Bei der Untertafel 41 ist die Halslänge zwar auch auf der Abszisse aufgetragen, doch wird die Ordinate von der Rotation in UpM der Stange 18 gebildet.

Die Untertafel 40 zeigt schließlich die Zuordnung von Halslänge und Temperatur.

Wie man aus der Fig. 7 erkennt, dienen die Gasdruck-Punkte, die den Halslängenpunkten 5 %, 10 %, 20 %, 30 % und 45 % entsprechen, als Stützpunkte für eine Kurve. Wenn kein Eintrag in der Tafel erfolgt, wird der letzte Wert bis 100 % beibehalten. Ein Parametersatz ist immer für 100 % Halslänge ausgelegt. Da jedoch in Fig. 6 die Parameter nur bis 45 % einsehbar sind, sind auch in der Fig. 7 die Parameter nur bis 45 % dargestellt. Mit den Tasten 51, 52 kann man allerdings die in Fig. 6 gezeigte Tabelle bis zu deren Ende scrollen.

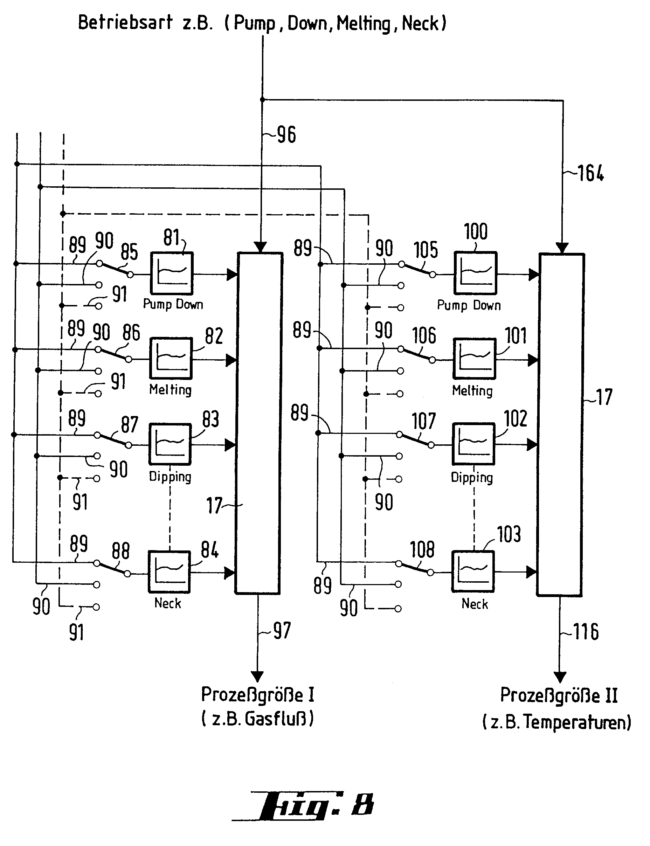

Diese und andere Kurven können, wie die Fig. 8 zeigt, mittels Funktionsgeneratoren derart erzeugt werden, daß sich die Zwischenwerte zwischen den Stützpunkten als Interpolationswerte ergeben.

Die Fig. 8 zeigt Funktionsgeneratoren 81 bis 84 bzw. 100 bis 103 für je eine Betriebsart 166, z. B. Pump Down, Melting, Neck, Regelung des Gasflusses etc., wobei die Funktionsgeneratoren 81 bis 84 für die Erzeugung einer ersten Prozeßgröße, z. B. den Gasfluß, zuständig sind, während die Funktionsgeneratoren 100 bis 103 für eine andere Prozeßgröße, beispielsweise für die automatische Regelung der Temperatur zuständig sind.

Im Funktionsgenerator 81 wird beispielsweise die in der Fig. 7, Untertafel 42, gezeigte Kurve generiert, die den Zusammenhang zwischen Halslänge und Gasdruck wiedergibt. Der Funktionsgenerator 101 erzeugt dagegen z. B. eine Kurve, die in der Untertafel 40 der Fig. 7 wiedergegeben ist.

Entsprechendes gilt für die übrigen Funktionsgeneratoren 82, 83, 84 und 100, 102, 103 gemäß Fig. 8.

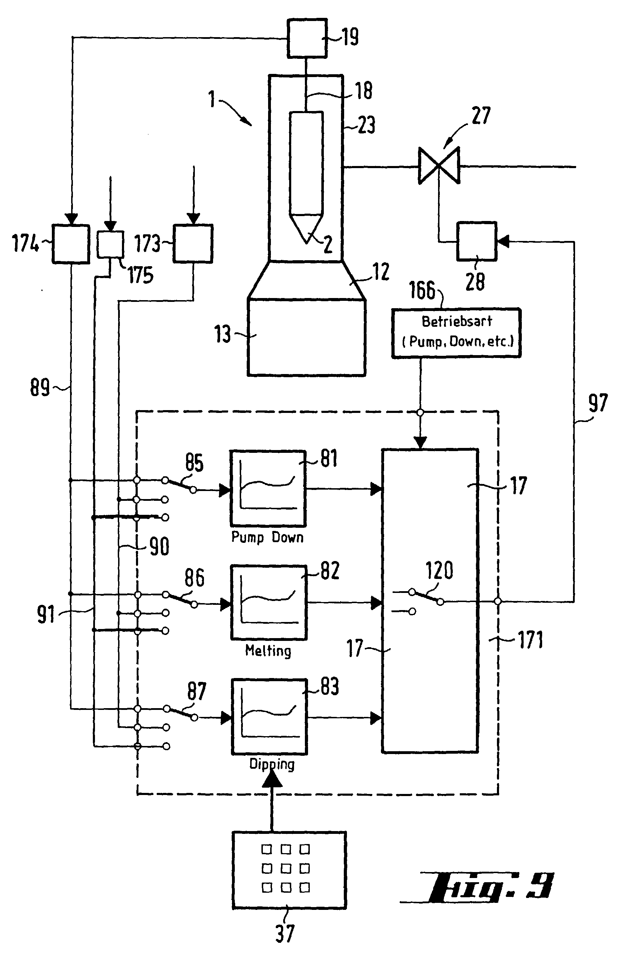

Die Abszissen der Funktionsgeneratoren 81 bis 84 bzw. 100 bis 103 sind über Schalter 85 bis 88 bzw. 105 bis 108 auf verschiedene Meßgrößen der Leitungen 89, 90, 91 umschaltbar. Die Zuleitungen 89 bis 91 führen die Signale eines vorgegebenen Umformers, der in der nachfolgenden Fig. 9 dargestellt ist. Diese Signale werden über die Schalter 85 bis 88 bzw. 105 bis 108 den Funktionsgeneratoren 81 bis 84 bzw. 100 bis 103 für die jeweilige Betriebsart durchgeschaltet. Im Beispiel "Neck" wird das Signal dem Funktionsgenerator 84 über den Schalter 88 zugeschaltet. Der Ausgang 97 führt die Sollwerte für z. B. den Gasfluß für den Hals 40, während der Ausgang 116 die Sollwerte für z. B. die Temperatur führt. Im allgemeinen sind es mehrere Parameter, z. B. Gasfluß und Gasdruck, deren Abhängigkeit von einer Führungsgröße, z. B. von der Halslänge, auf diese Weise dargestellt werden können, so daß für die Darstellung zweier Kurven aufgrund einer Umschaltung ein einziger Funktionsgenerator ausreichend ist.

In der Fig. 9 ist noch einmal eine schematische Übersicht der gesamten Anlage in Verbindung mit der Anordnung gemäß Fig. 8 dargestellt. Die Vorrichtung 1 mit dem Behälter 12, 13, dem Rohr 23, dem Motor 19 und dem Ventil 27, das von einem Stellmotor 28 betätigt wird, ist im oberen Bereich dargestellt. Man erkennt hierbei, daß eine Prozeßgröße, z. B. der von einem Gerät 173 gemessene Gasdruck, über eine Leitung 90 und einen Schalter 85 auf einen Funktionsgenerator 81 gegeben wird, der seine Funktion der Einrichtung 17 zuführt, welche diese Funktion auf einen Signal-Umformer 28 gibt, um das Ventil 27 entsprechend einzuschalten.

Mit 172, 173 ist ein Zeitgeber bezeichnet, während 174 ein Impulsgeber ist.

Die Geräte 173, 174, 175 sind Prozeßzustandssensoren, wobei 174 ein Prozeßzustandssensor für den Kristallziehantrieb ist, der z. B. die aktuelle Kristallposition ermittelt. Die Prozeßzustandssensoren 173, 175 dienen z. B. zum Ermitteln des Kristallgewichts bzw. der Temperatur. Die für die jeweilige Betriebsart relevanten Prozeßzustandswerte können über die Umschalter 85, 86, 87 umgeschaltet werden.

Bei dem Umschalter 120 handelt es sich um einen Betriebsarten-Umschalter, mit dem für jede der Ausgangsgrößen bzw. Stellgrößen zur Anlage hin der für diese Betriebsart zugeordnete Funktionsgenerator-Ausgang, z. B. 81, ausgewählt wird.

Wie sich aus den vorstehenden Figurenbeschreibungen ergibt, bezieht sich die Erfindung auf eine Einrichtung zur automatischen Kontrolle von Kristallzüchtungsprozessen mit Hilfe von Prozeßmeßwerten, Prozeßparametern und Variablen bzw. mit Hilfe von Eingangs- und Ausgangswerten, die jeweils verschiedenen Prozeß-Phasen und Kristallabschnitten zugeordnet werden. Dabei wird für die verschiedenen Verfahrensstrategien und Parameterzuordnungen eine einzige, allgemeingültige Einrichtung für die Ermittlung der Prozeßausgangsgrößen verwendet, und zwar ohne Einschränkung für alle unterschiedlichen Prozeßphasen und Prozeßstrategien.

Es sind folglich ausnahmslos alle für die Prozeßkontrolle erforderlichen Prozeßvariablen oder Ausgangsgrößen in das gleiche Prozeß-Kontrollsystem einbezogen, so daß keine für einen Prozeß erforderlichen Prozeß-Variablen oder Ausgangsgrößen außerhalb des Prozeß-Kontrollsystems eingesetzt werden müssen. Es werden auch keine Prozeßschritte oder -phasen mit Mitteln außerhalb des erwähnten Prozeß-Kontrollsystems geregelt oder gesteuert.

Die Einrichtung für die Ermittlung der Prozeß-Ausgangsgrößen für eine bestimmte Betriebsart, z. B. einer Prozeßphase oder eines Kristall-Abschnitts, ist stets auf gleiche Weise ausgeführt.

Es wird also immer das gleiche Muster, wie in Fig. 6 dargestellt, für alle anderen Parameter, die z. B. in Fig. 4 wiedergegeben sind, verwendet.

Die Einrichtungen zur Ermittlung von Prozeß-Ausgangsgrößen werden von Eingangsgrößen wie z. B. aktuellen Prozeß-Meßwerten, simulierten oder modellierten Prozeßwerten oder prozeßtechnischen Vorgaben, Rampenfunktionen, Sollwerten etc. gesteuert.

Die Eingangsgrößen für die Einrichtungen zur Ermittlung von Prozeß-Ausgangsgrößen sind dabei auswählbar und umschaltbar.

Außerdem wird die Gleichartigkeit der Einrichtungen zur Ermittlung von ProzeßAusgangsgrößen für alle verschiedenen Prozeßparameter auch für alle verschiedenen Prozeß-Phasen, d. h. Betriebsarten und Kristallabschnitte zum automatischen Vergleich bzw. zur automatischen Auswertung bzw. zur automatischen Dokumentation real durchgeführter Prozesse verwendet.

Mit der Erfindung ist es u. a. dem Benutzer möglich, Prozesse ablaufen zu lassen, die der Entwickler der Erfindung selbst nicht kennt d. h. es können "geheime" Prozesse durchgeführt werden, indem z. B. die vorgegebenen Zahlenwerte geändert werden.

## Patentansprüche

1. Einrichtung zum Steuern von Kristallzüchtungsprozessen, bei denen verschiedene Prozeß-Phasen unterschieden werden, beispielsweise die Phase des Einschmelzvorgangs des Ausgangsmaterials, des Abkühlens der Restschmelze oder die Phasen, während denen der Hals, die Schulter oder der Körper des Kristalls einer bestimmten Regelstrategie unterworfen werden, wobei Meßwerte, z. B. der Durchmesser des Kristall-Halses, während dieser Phase erfaßt und einer Auswerteeinrichtung zugeführt werden, welche die Prozeßvariablen wie Heiztemperatur eines Tiegels beeinflußt, **da-durch gekennzeichnet,** daß die Auswerteeinrichtung eine für alle Phasen gleichartig aufgebaute Zuordnungseinrichtung (40, 41, 42) ist, die jedem während einer Phase gemessenen Wert (z. B. Halsdurchmesser eines Kristalls) eine bestimmte Prozeßvariable (z. B. Temperatur des Tiegels oder Kristall-Drehgeschwindigkeit) zuordnet.

2. Einrichtung nach Anspruch 1, **dadurch gekennzeichnet,** daß die zugeordnete Prozeßvariable veränderbar ist.

3. Einrichtung nach Anspruch 1, **dadurch gekennzeichnet,** daß die zugeordneten Prozeßvariablen als numerische Daten in einem Speicher abgespeichert sind.

4. Einrichtung nach Anspruch 1, **dadurch gekennzeichnet,** daß die zugeordneten Prozeßvariablen als Funktionskurven (Fig. 7) abgespeichert sind.

5. Einrichtung nach Anspruch 4, **dadurch gekennzeichnet,** daß die Funktionskurven mittels Funktionsgeneratoren (80 bis 83, 100 bis 103) realisiert sind.

6. Einrichtung nach Anspruch 3 oder Anspruch 4, **dadurch gekennzeichnet,** daß die Prozeßvariablen auf Tafeln (40, 41, 42) dargestellt sind.

7. Einrichtung nach Anspruch 1, **dadurch gekennzeichnet,** daß statt Meßwerten Zeiten vorgegeben sind.

8. Einrichtung nach Anspruch 6, **dadurch gekennzeichnet,** daß die Tafeln (40 bis 42) Zeilen und Spalten aufweisen, wobei in den Spalten verschiedene numerische Werte angegeben sind.

9. Einrichtung nach Anspruch 8, **dadurch gekennzeichnet,** daß in einer ersten Spalte Zahlenwerte für eine Prozeßgröße (z. B. die Halslänge) angegeben sind, während in den übrigen Spalten Prozeßdaten (z. B. für den Gasfluß oder den Gasdruck) angegeben sind, wobei die in einer Zeile angeordneten Größen bzw. Daten einander zugeordnet sind.

10. Einrichtung nach Anspruch 9, **dadurch gekennzeichnet,** daß Spalten mit weiteren Daten zuschaltbar sind

11. Einrichtung nach Anspruch 1**, dadurch gekennzeichnet,** daß auf einem Bildschirm eines Monitors (38) Tafeln (40, 41, 42) darstellbar sind von denen jede wenigstens eine Prozeßvariable (z. B. den Gasdruck), in Abhängigkeit von der Phase (z. B. Bereich des Kristall-Halses) zahlenmäßig darstellt.

12. Einrichtung nach Anspruch 1, **dadurch gekennzeichnet,** daß auf einem Bildschirm eine Darstellung aufrufbar ist, die eine Kristallziehvorrichtung (1, 23, 27, 32, 78, 79, 98, 99, 117, 118, 119) bildlich darstellt, und daß diese Darstellung gleichzeitig Felder (124 bis 129) abbildet, in welchen Prozeßgrößen, z. B. Umdrehungszahl des Kristalls, Hub des Tiegels, Temperatur einer Heizung, angegeben sind.

13. Einrichtung nach Anspruch 12, **dadurch gekennzeichnet,** daß die Bildschirmdarstellung eine Taste (137) enthält, bei deren Aktivierung eine Anzeige "Parameter Page Selection" (Fig. 4) dargestellt wird, welche verschiedene Prozeßparameter-Felder (144 bis 162) zeigt.

14. Einrichtung nach Anspruch 13, **dadurch gekennzeichnet,** daß bei der Aktivierung eines Prozeßparameter-Feldes (z. B. 148 Neck) wenigstens eine Tafel (42) aufgerufen und dargestellt wird, welche eine Prozeßgrößen-Zuordnung zwischen Halslänge einerseits und Gasfluß bzw. Gasdruck oder Drehzahl andererseits zeigt.
